Europäisches Patentamt

European Patent Office

Office européen des brevets

(11) Veröffentlichungsnummer: **0 426 988 A1**

## (12) EUROPÄISCHE PATENTANMELDUNG

(21) Anmeldenummer: 90118799.7

(22) Anmeldetag: 01.10.90

(51) Int. Cl.⁵: **H01P 5/10, H03H 7/42**

(30) Priorität: 09.11.89 CH 4048/89

(43) Veröffentlichungstag der Anmeldung:
15.05.91 Patentblatt 91/20

(84) Benannte Vertragsstaaten:
CH DE FR GB LI

(71) Anmelder: **ASEA BROWN BOVERI AG**

**CH-5401 Baden(CH)**

(72) Erfinder: **Gassmann, Felix**
**Etzelweg 65**
**CH-8038 Zürich(CH)**
Erfinder: **Snedkerud, Ole**
**Pestalozzistrasse 6**
**CH-5200 Windisch(CH)**

(54) **Symmetrierungsschleife.**

(57) Bei einer Symmetrierungsschleife mit zwei Leiterstücken (4, 17) in einem Gehäuse (5), wobei das erste Leiterstück (4) als Koaxialleitung ausgebildet ist über eine erste Teillänge (l1) und das Ende der Teillänge (l1) mit dem zweiten Leiterstück (17) verbunden ist, wird durch eine spezielle Wahl der ersten Teillänge (l1) und Anordnung eines variablen Kondensators (C1) am symmetrischen Ausgang (2) ein kompakter und robuster Aufbau sowie eine einfache Abstimmbarkeit erreicht.

FIG.3

EP 0 426 988 A1

## SYMMETRIERUNGSSCHLEIFE

TECHNISCHES GEBIET

Die vorliegende Erfindung bezieht sich auf das Gebiet der Hochfrequenztechnik. Sie betrifft insbesondere eine Symmetrierschleife, umfassend

(a) ein Gehäuse mit einem Innenraum;

(b) innerhalb des Gehäuses ein erstes Leiterstück mit einer ersten und zweiten Teillänge, welches erste Leiterstück auf der ersten Teillänge als Koaxialleitung mit einem koaxialen Innenleiter ausgebildet ist, auf der einen Seite als Koaxialleitung durch das Gehäuse tritt und dort einen koaxialen Eingang bildet und auf der anderen Seite innerhalb des Gehäuses frei endet;

(c) innerhalb des Gehäuses ein zweites Leiterstück mit der ersten und zweiten Teillänge, welches zweite Leiterstück beabstandet von und parallel zum ersten Leiterstück verläuft, auf der Seite des koaxialen Eingangs mit dem Gehäuse verbunden ist und auf der anderen Seite innerhalb des Gehäuses frei endet;

(d) im ersten Leiterstück am Ende der ersten Teillänge eine Oeffnung, durch welche der koaxiale Innenleiter rechtwinklig aus dem ersten Leiterstück heraustritt und mit dem zweiten Leiterstück verbunden ist; und

(e) zwei symmetrische Ausgangsleitungen, welche auf der zweiten Teillänge jeweils mit einem der Leiterstücke verbunden sind, aus dem Gehäuse herausführen und dort einen symmetrischen Ausgang bilden;

Eine solche Symmetrierschleife ist z.B. aus H. Meinke und F. W. Gundlach, Taschenbuch der Hochfrequenztechnik, 3. Auflage, Springer-Verlag (1968), S.394 (Abb.18.11), bekannt.

STAND DER TECHNIK

In der Technik der Rundfunksender werden sogenannte Symmetrierschleifen oder Baluns (Balancing Units) mit einem koaxialen Eingang und einem symmetrischen Ausgang verwendet, um beispielsweise erdsymmetrische Antennen über eine koaxiale Speiseleitung versorgen zu können.

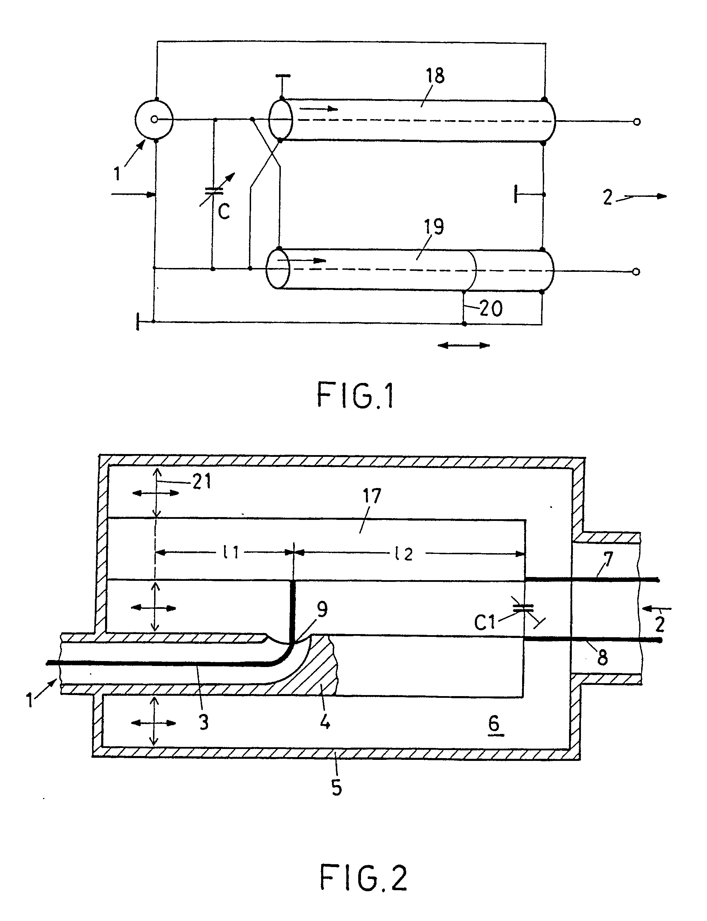

Eine mögliche Realisierung für einen solchen Balun (Fig.1) besteht aus zwei parallelen koaxialen Leitungen 18 und 19, die auf die dargestellte Weise zusammengeschaltet sind. Zur Abstimmung auf unterschiedliche Frequenzen im gewünschten Frequenzbereich von etwa 4 MHz bis 26 MHz sind ein variabler Kondensator C am Eingang und ein Kurzschlussschieber 20 am ausgangsseitigen Ende der zweiten Leitung 19 vorgesehen.

Dieser Balun-Typ weist den Nachteil auf, dass bei einer unsymmetrischen Last von nur einigen pF eine grosse Spannungsunsymmetrie entsteht (Resonanz). Diese Empfindlichkeit gegen Unsymmetrien lässt sich nicht durch eine einfache Modifikation beheben.

Häufig ist mit der Umsymmetrierung im Balun auch eine Widerstandstransformation verbunden: Bei der in Fig.1 dargestellten Lösung wird im Verhältnis 1:4 eine unbalancierte Eingangsimpedanz von 50 Ω auf symmetrische 200 Ω heraufsetzt.

Um höhere Transformationsverhältnisse (z.B. 1:6, d.h. von 50 Ω auf 300 Ω) erreichen zu können, muss dann ein zusätzlicher Transformator vom Leitungstyp mit einer Länge von etwa 12 m nachgeschaltet werden, der schwierig herzustellen ist und - vor allem bei tieferen Frequenzen - relativ grosse Impedanzschwankungen aufweist.

Es wäre nun denkbar, den eingangs erwähnten Balun-Typ, der sich nicht an unterschiedliche Frequenzen anpassen lässt, so zu modifizieren, dass er für einen grösseren Frequenzbereich brauchbar ist. Wie in Fig.2 dargestellt, könnte eine solche Modifikation einen eingangsseitigen Kurzschlussschieber 21 und einen ausgangsseitigen variablen Kondensator C1 umfassen.

Der Nachteil eines solchen Baluns läge darin, dass bei einer Aenderung der Frequenz zwei Parameter eingestellt werden müssten. Ausserdem führen Schieber mit ihren Kontakten zu Problemen wie Abnutzung, Knicken der Kontakte und Verbrennungen.

DARSTELLUNG DER ERFINDUNG

Aufgabe der vorliegenden Erfindung ist es nun, eine Symmetrierungsschleife zu schaffen, die zumindest im Frequenzbereich 4MHz bis 26 MHz ein Transformationsverhält nis grösser 1:4 erlaubt, sich einfach abstimmen lässt und sich durch einen robusten Aufbau auszeichnet.

Die Aufgabe wird bei einer Symmetrierungsschleife der eingangs genannten Art dadurch gelöst, dass

(f) auf der zweiten Teillänge zwischen dem ersten und zweiten Leiterstück wenigstens ein Kondensator angeordnet ist; und

(g) die erste Teillänge so gewählt wird, dass die Symmetrierungsschleife ausschliesslich mit dem wenigstens einen Kondensator auf verschiedene Frequenzen abgestimmt werden kann.

Der Erfindung liegt die Erkenntnis zugrunde, dass bei einem Balun der in Fig.2 dargestellten Art die Parameter (Leitungsimpedanzen und Leitungslängen) so gewählt werden können, dass für die Abstimmung auf verschiedene Frequenzen ein variabler Kondensator am symmetrischen Ausgang genügt.

Auf diese Weise lässt sich ein robuster und kompakter Balun realisieren, der zugleich sehr einfach abgestimmt werden kann.

Ausführungsbeispiele für die Erfindung ergeben sich aus den Unteransprüchen.

## KURZE BESCHREIBUNG DER ZEICHNUNG

Die Erfindung soll nachfolgend anhand von Ausführungsbeispielen im Zusammenhang mit der Zeichnung näher erläutert werden. Es zeigen

Fig.1 die Prinzipschaltung eines abstimmbaren Baluns nach dem Stand der Technik;

Fig.2 den möglichen Aufbau eines anderen abstimmbaren Baluns;

Fig.3-8 verschiedene Ausführungsbeispiele für einen Balun nach der Erfindung, die sich durch unterschiedliche Ausgestaltung der Mittenanzapfung unterscheiden;

Fig. 9-9B weitere Ausführungsbeispiele für einen Balun nach der Erfindung, bei dem die Kondensator-Anschlusspunkte verschoben sind; und

Fig. 10A-C Ausführungsbeispiele für einen Balun nach der Erfindung, bei denen mehrere Kondensatoren oder eine zusätzliche Induktivität Verwendung finden.

## WEGE ZUR AUSFÜHRUNG DER ERFINDUNG

Fig.1 zeigt eine bekannte Symmetrierungsschleife (Balun), wie sie in Kurzwellensendern verwendet wird und in ähnlicher Form z.B. in der Druckschrift Brown Boveri Mitt., Heft 2/3, 1972, S.97-103 dargestellt ist.

Der bekannte Balun hat einen koaxialen Eingang 1 und einen symmetrischen Ausgang 2, zwischen denen zwei koaxiale Leitungen 18 und 19 parallelgeschaltet sind. Abgestimmt wird dieser Balun durch einen am Eingang liegenden variablen Kondensator C und eine Kurzschlussbrücke 20, mit der die effektive Länge der zweiten Leitung 19 verändert werden kann.

Nachteilig ist hier einerseits, dass der Balun in dieser Form auf ein Transformationsverhältnis von 1:4 beschränkt ist. Auf der anderen Seite müssen bei einer Aenderung der Frequenz zwei Parameter (Kapazität von C und effektive Länge der zweiten Leitung 19) verändert werden.

Eine mögliche Lösung für höhere Transformationsverhältnisse, die auf dem im Buch von Meinke und Gundlach gezeigten Balun-Typ basiert, ist in der Fig.2 wiedergegeben. Im Innenraum 6 eines Gehäuses 5 sind parallel zwei gleichlange Leiterstücke 4 und 17 so angeordnet, dass sie jeweils an ihrem einen Ende mit dem Gehäuse 5 leitend verbunden sind und auf der anderen Seite frei im Innenraum 6 enden.

Das erste Leiterstück 4 ist auf einer ersten Teillänge 11 als Koaxialleitung mit einem koaxialen Innenleiter 3 ausgebildet. Diese Koaxialleitung endet auf der einen Seite in dem koaxialen Eingang 1. Auf der anderen Seite tritt der Innenleiter 3 durch eine Oeffnung 9 rechtwinklig aus dem ersten Leiterstück 4 aus, läuft zum gegenüberliegenden zweiten Leiterstück 17 und ist mit diesem dort leitend verbunden. Auf einer zweiten Teillänge 12 sind beide Leiterstücke 4, 17 gleichartig.

An den freien Enden der Leiterstücke 4 und 17 ist jeweils eine symmetrische Ausgangsleitung 8 bzw. 7 angeschlossen. Beide symmetrische Ausgangsleitungen 7, 8 zusammen bilden den symmetrischen Ausgang 2.

Zur Abstimmung des Baluns gemäss Fig.2 sind zwei Elemente vorgesehen: Zum Einen lässt sich die erste Teillänge $l1$ mittels eines Kurzschlussschiebers 21 verändern. Zum Anderen sind die freien Enden der Leiterstücke 4, 17 über einen variablen Kondensator C1 miteinander verbunden.

Obgleich dieser Balun Transformationsverhältnisse grösser 1:4 zulässt, lässt er sich wegen der zwei Elemente C1 und 21 nur schwer abstimmen und ist durch den mechanischen Kurzschlussschieber 21 anfällig gegen Störungen.

Bei der Berechnung der verschiedenen Parameter eines Baluns gemäss Fig.2 in Abhängigkeit von der Frequenz wurde nun festgestellt, dass bei einer geeigneten Wahl dieser Parameter (Leitungsimpedanz $Z_0$, erste und zweite Teillänge 11 bzw. 12) der Balun über einen Frequenzbereich von 4 bis 26 MHz abgestimmt werden kann, ohne dass die erste Teillänge $l1$ wesentlich oder überhaupt geändert werden muss. Damit entfällt die Notwendigkeit des Kurzschlussschiebers 21; der Balun kann ausschliesslich mit Hilfe des variablen Kondensators C1 auf die Frequenz abgestimmt werden.

Es gibt also wenigstens einen Wert von $l1$, bei dem $l1$ über den ganzen Frequenzbereich konstant gehalten werden kann. Werden Abweichungen im VSWR zugelassen, gibt es sogar eine Vielzahl von $l1$-Werten, die kostant bleiben.

Im nachfolgenden Beispiel wird eine Eingangsimpedanz von 50 Ω angenommen. Allgemein kann jedoch am Eingang eine beliebige Impedanz gewählt werden.

Beispiel:

Eingangsimpedanz: 50Ω

Ausgangsimpedanz: 300 Ω

l1 + l2: 2,704 m

l1: 1,104 m

Leitungsimpedanz: 111 Ω

Wählt man die Parameter in der im Beispiel angegebenen Weise, wird eine nahezu ideale Abstimmung des Baluns erreicht, wenn die Kapazität des Kondensators C1 von 1571 pF bei 4 MHz auf 25,1 pF bei 26 MHz verändert wird.

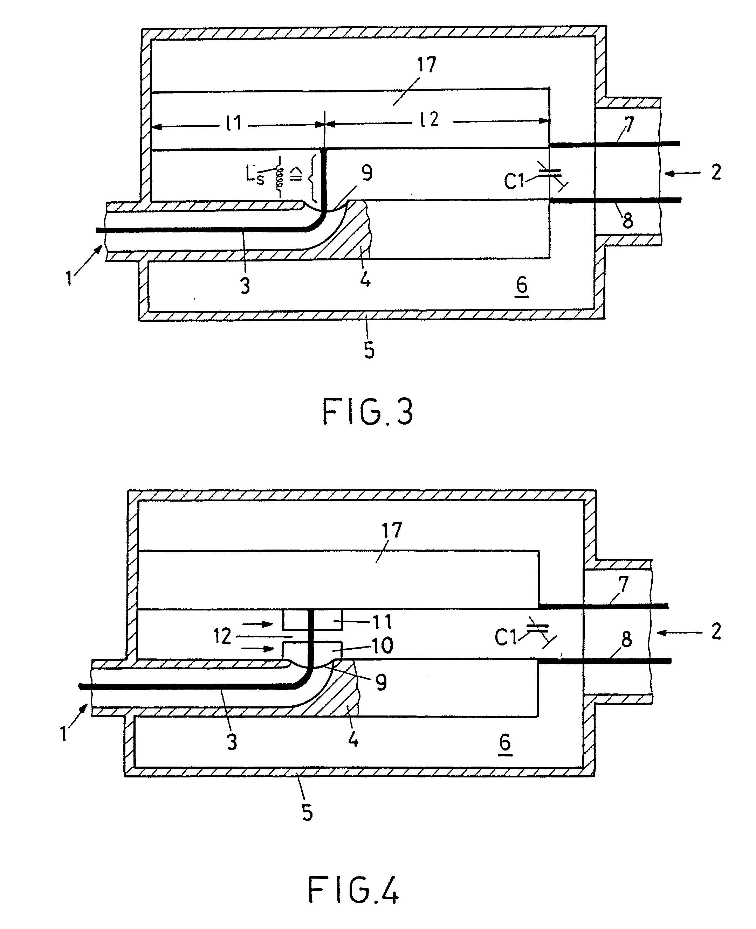

In seiner einfachsten Ausführungsform hat ein solcher Balun dann die in Fig.3 dargestellte Konfiguration. Er ist kompakt, benötigt für eine (1:6)-Transformation keinen zusätzlichen Leitungstransformator (von 200 auf 300 Ω) und kann mit nur einem, relativ kleinen Kondensator abgestimmt werden.

Die einfache Ausführungsform gemäss Fig .3 kann allerdings aus folgenden Gründen weiter verbessert werden:

1. Das SWR am 50Ω-Eingang ist bei idealer 300Ω-Last jeweils bei der tiefsten und höchsten Betriebsfrequenz grösser als 1,35. Deshalb ist der Balun in dieser Form für einen Einsatz bei einer Leistung von mehr als 50 kW nur bedingt geeignet.

2. Zwar ist die Spannungssymmetrie bei tiefen Frequenzen (35 % tiefer als die maximale Betriebsfrequenz) und bei unsymmetrischer Last tatsächlich besser als beim (1:4)-Balun nach Fig. 1, jedoch verschlechtert sich die Symmetrie exponentiell in der Nähe der höchsten Be triebsfrequenz. Die Spannungs-Unsymmetrie kann dann am Ausgang des Baluns je nach Last bis zu 1:10 betragen.

Die Ursachen dieser Probleme liegen bei Randeffekten, die durch den vorgegebenen konstruktiven Aufbau verursacht werden:

1. Ein erster Störfaktor ist die Streuinduktivität $L_s$, die durch die Mittenanzapfung im Balun entsteht (in Fig.3 schematisch eingezeichnet). Diese Streuinduktivität $L_s$ verschlechtert hauptsächlich das SWR und hat auch einen Einfluss auf die Symmetrie-Empfindlichkeit.

2. Die Empfindlichkeit des Baluns auf asymmetrische Last hängt im wesentlichen von der Wahl der minimal einstellbaren Kapazität und der dazugehörigen höchsten Betriebsfrequenz ab.

Der erste Effekt (Streuinduktivität) kann durch die in Fig.4 dargestellte Weiterbildung des Baluns aus Fig.3 behoben werden: Die Mittenanzapfung wird von beiden Seiten symmetrisch mit zwei Rohrstücken 10 und 11 "zugedeckt" und dabei in der Mitte je nach geforderter Spannungsfestigkeit ein Schlitz 12 offen gelassen. Die Rohrstücke 10 und 11 bilden dann zusammen mit dem koaxialen Innenleiter 3 der Mittenanzapfung jeweils eine Koaxialleitung mit 50 Ω (gemäss dem Beispiel) oder einer anderen Leitungsimpedanz.

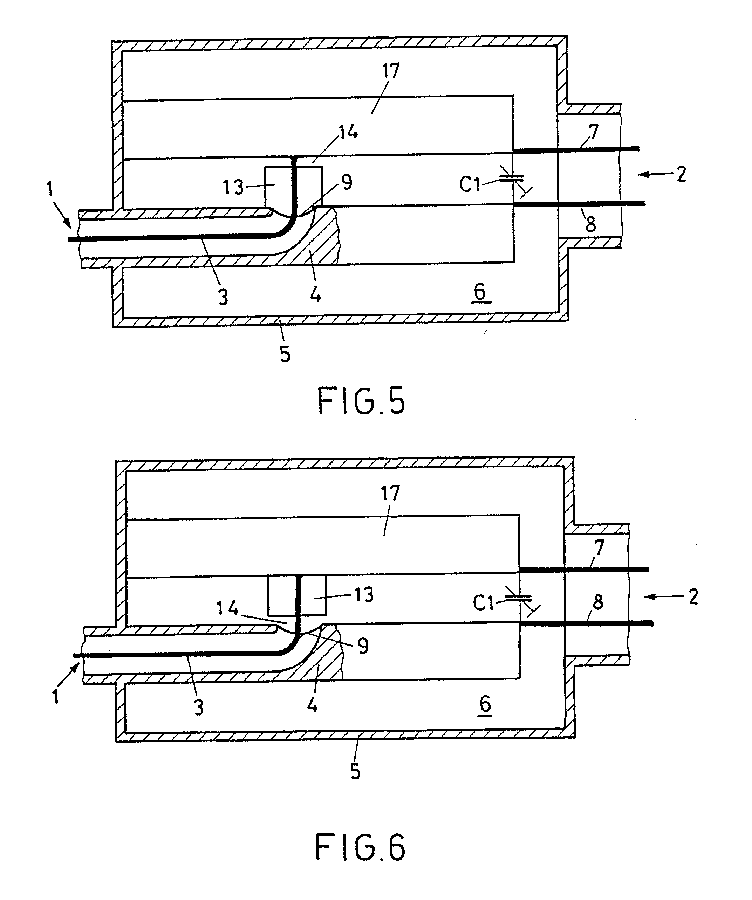

Es besteht weiterhin auch die Möglichkeit, nur jeweils von einer Seite ein Rohrstück 13 einzubauen, welches zur anderen Seite hin durch einen Schlitz 14 getrennt ist (Fig.5 und 6). Die Schlitzöffnung wird dabei von der Spannungsbelastung bestimmt.

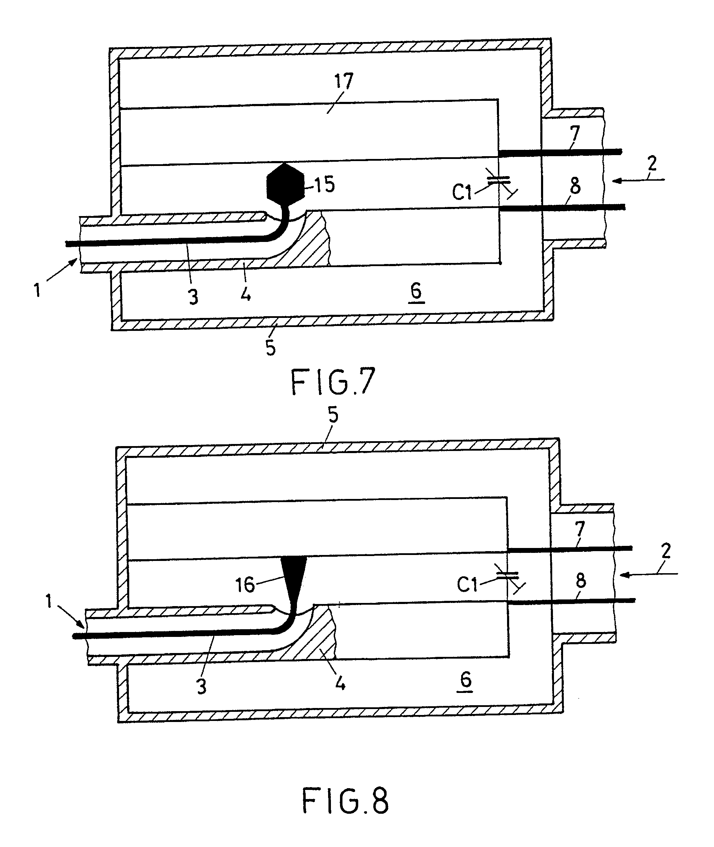

Andere Varianten zur Reduktion der Streuinduktivität zeigen die Fig.7 und 8. Hier wird der Aussendurchmesser der Anzapfung (des koaxialen Innenleiters 3 im Zwischenraum zwischen den Leiterstücken 4 und 17) in Form von Verdickungen 15 bzw. 16 erhöht und damit die Induktivität erniedrigt. Dabei muss darauf geachtet werden, dass die Verdickungen 15, 16 nicht innerhalb der im ersten Leiterstück 4 vorhandenen 50Ω-Koaxialleitung angebracht werden. Dies ist der Grund für die gewählte doppelt konische (Fig. 7) bzw. einfach konische (Fig.8) Form.

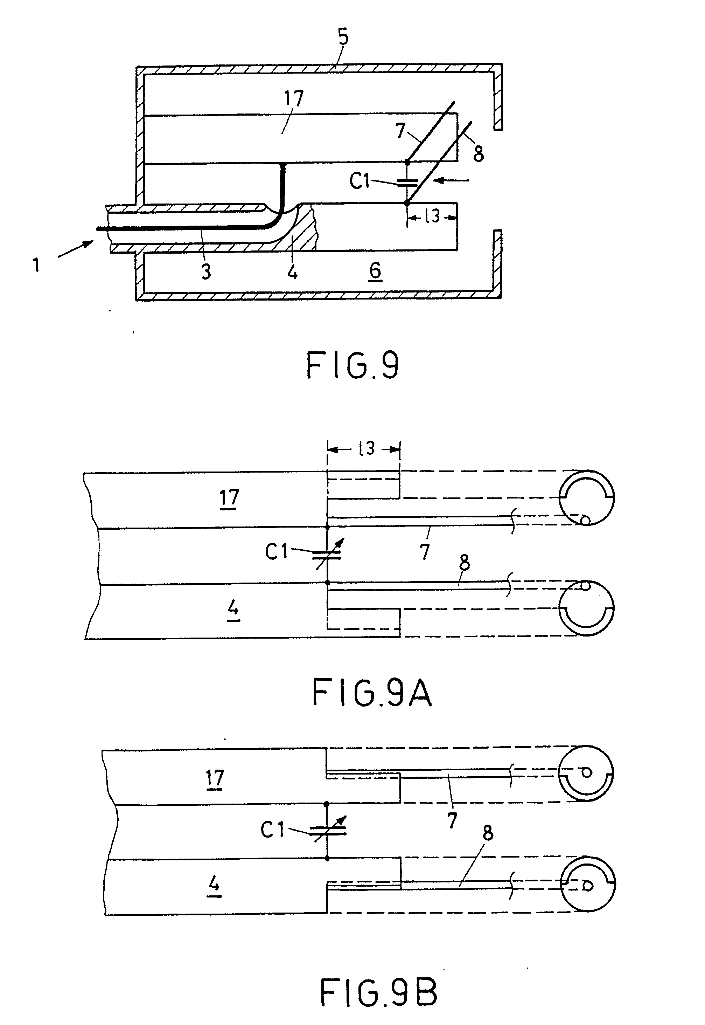

Eine weitere Möglichkeit zur Kompensation der Streuinduktivität $L_s$ ist das Verschieben des Kondensators Cl um eine Teillänge 13 (ca. 20 cm pro 100 nH Streuinduktivität) in Richtung der Mittenanzapfung (Fig.9). Auch der Abgriff für den symmetrischen Ausgang 2 mittels der symmetrischen Ausgangsleitungen 7, 8 hätte dann direkt über dem Kondensator C1 zu erfolgen. Zwei Ausführungsbeispiele für einen solchen Abgriff, die mechanisch einfach herzustellen sind, sind in den Fig.9A und B wiedergegeben.

Der zweite Effekt (Empfindlichkeit auf asymmetrische Last) kann dadurch verringert werden, dass für die minimale einstellbare Kapazität $C_{min}$ des Kondensators C1 die folgende Bedingung erfüllt wird:

$$C_{min}/C_{asym} > 4,$$

wobei mit $C_{asym}$ die maximal auftretende Asymmetrie am Ausgang bezeichnet ist.

Weitere Ausführungsbeispiele ergeben sich (Fig. 10A-C), wenn der einzelne Kondensator C1 durch eine Mehrzahl von Kondensatoren C1...C8 ersetzt wird.

In Fig. 10A sind zusätzlich zum variablen Kondensator C1 zwischen den Leiterstücken 4 und 17 noch zwei Kondensatoren C2, C3 (variabel oder nicht) vorgesehen, die jeweils zwischen ein Leiterstück und das Gehäuse 5 geschaltet sind.

In Fig.10B sind zwischen den Leiterstücken 4, 17 zwei variable Kondensatoren C4, C5 in Serie geschaltet und mit dem Mittelpunkt geerdet. Diese Lösung bringt verschiedene Vorteile mit sich, wie z.B. eine bessere Immunität gegen Unsymmetrie auf der Transmissionsleitung.

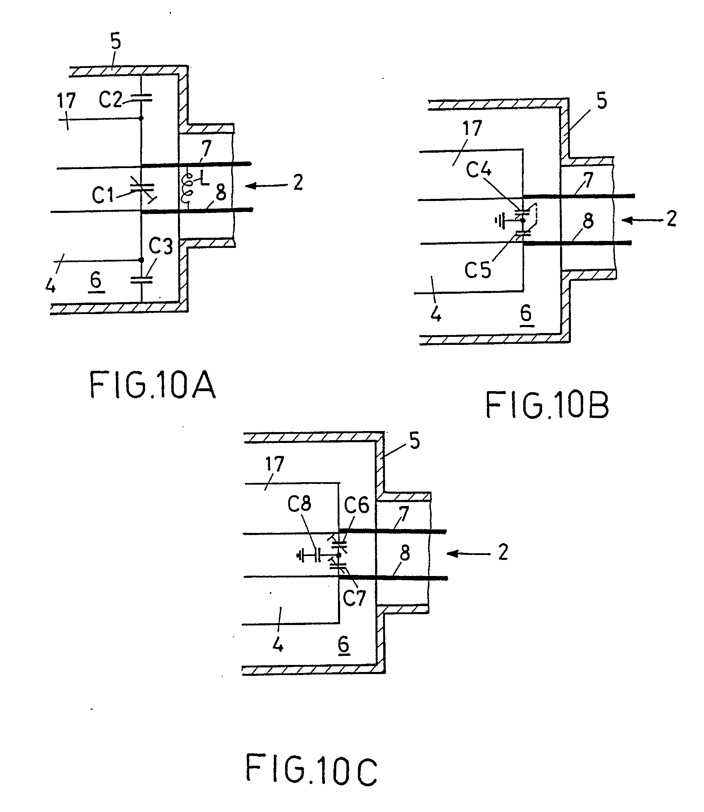

Die Mittelpunktserdung aus Fig. 10B kann aber auch über einen weiteren Kondensator C8 erfolgen (Fig. 10C).

In allen Fällen kann der Frequenzbereich des Baluns dadurch erhöht werden, dass in den symmetrischen Ausgang -wie im Beispiel der Fig.10A dargestellt - eine zusätzliche Induktivität L eingefügt wird. Hierdurch lässt sich die Kompensation auf höhere Frequenzbereiche ausdehnen, für welche die Kapazität C des Kondensator C1 kleiner als $C_{min}$ sein müsste.

## Ansprüche

1. Symmetrierungsschleife, umfassend
(a) ein Gehäuse (5) mit einem Innenraum (6);
(b) innerhalb des Gehäuses (5) ein erstes Leiterstück (4) mit einer ersten und zweiten Teillänge (11 bzw. 12), welches erste Leiterstück (4) auf der ersten Teillänge (l1) als Koaxialleitung mit einem koaxialen Innenleiter (3) ausgebildet ist, auf der einen Seite als Koaxialleitung durch das Gehäuse (5) tritt und dort einen koaxialen Eingang (1) bildet und auf der anderen Seite innerhalb des Gehäuses (5) frei endet;
(c) innerhalb des Gehäuses (5) ein zweites Leiterstück (17) mit der ersten und zweiten Teillänge (11 bzw. 12), welches zweite Leiterstück (17) beabstandet von und parallel zum ersten Leiterstück (4) verläuft, auf der Seite des koaxialen Eingangs (1) mit dem Gehäuse (5) verbunden ist und auf der anderen Seite innerhalb des Gehäuses (5) frei endet;
(d) im ersten Leiterstück (4) am Ende der ersten Teillänge (11) eine Oeffnung (9), durch welche der koaxiale Innenleiter (3) rechtwinklig aus dem ersten Leiterstück (4) heraustritt und mit dem zweiten Leiterstück (17) verbunden ist; und
(e) zwei symmetrische Ausgangsleitungen (7,8), welche auf der zweiten Teillänge (12) jeweils mit einem der Leiterstücke (4,17) verbunden sind, aus dem Gehäuse (5) herausführen und dort einen symmetrischen Aus gang (2) bilden;
dadurch gekennzeichnet, dass
(f) auf der zweiten Teillänge (12) zwischen dem ersten und zweiten Leiterstück (4 bzw. 17) wenigstens ein variabler Kondensator (C1...C8) angeordnet ist.
(g) die erste Teillänge (11) so gewählt wird, dass die Symmetrierungsschleife ausschliesslich mit dem wenigstens einen Kondensator (C1...C8) auf verschiedene Frequenzen abgestimmt werden kann.

2. Symmetrierungsschleife nach Anspruch 1, dadurch gekennzeichnet, dass zur Verringerung der Streuinduktivität der koaxiale Innenleiter (3) zwischen dem ersten und zweiten Leiterstück (4 bzw. 17) von wenigstens einem Rohrstück (10,11,13) umgeben ist, welches mit einem der Leiterstücke (4,17) verbunden ist und zusammen mit dem koaxialen Innenleiter (3) eine Koaxialleitung bildet.

3. Symmetrierungsschleife nach Anspruch 2, dadurch gekennzeichnet, dass zwei Rohrstücke (10,11) vorgesehen sind, welche jeweils mit einem der Leiterstücke (4,17) verbunden und voneinander durch einen Schlitz (12) getrennt sind.

4. Symmetrierungsschleife nach Anspruch 2, dadurch gekennzeichnet, dass nur ein Rohrstück (13) vorgesehen ist, welches mit einem der Leiterstücke (4,17) verbunden und von dem anderen Leiterstück durch einen Schlitz (14) getrennt ist.

5. Symmetrierungsschleife nach Anspruch 1, dadurch gekennzeichnet, dass zur Verringerung der Streuinduktivität der koaxiale Innenleiter (3) zwischen den beiden Leiterstücken (4,17) eine Verdickung (15,16) aufweist.

6. Symmetrierungsschleife nach Anspruch 5, dadurch gekennzeichnet, dass die Verdickung (15,16) einfach oder doppelt konisch ausgeführt ist.

7. Symmetrierungsschleife nach Anspruch 1, dadurch gekennzeichnet, dass zur Verringerung der Streuinduktivität der wenigstens eine Kondensator (C1...C8) die beiden Leiterstücke (4,17) an einer Stelle verbindet, die von den freien Enden der Leiterstücke (4,17) um eine dritte Teillänge (13) entfernt ist.

8. Symmetrierungsschleife nach Anspruch 1, dadurch gekennzeichnet, dass zwischen dem ersten und zweiten Leiterstück (4 bzw. 17) zwei Kondensatoren (C4,C5) in Serie geschaltet und in der Mitte geerdet sind.

9. Symmetrierungsschleife nach Anspruch 8, dadurch gekennzeichnet, dass die Erdung über einen weiteren Kondensator (C8) erfolgt.

10. Symmetrierungsschleife nach Anspruch 1, dadurch gekennzeichnet, dass die freien Enden der Leiterstücke (4,17) über jeweils einen weiteren Kondensator (C2 bzw. C3) mit dem Gehäuse (5) verbunden sind.

11. Symmetrierungsschleife nach Anspruch 1, dadurch gekennzeichnet, dass zur Erweiterung des Frequenzbereichs zwischen die symmetrischen Ausgangsleitungen (7,8) eine zusätzliche Induktivität (L) geschaltet ist.

12. Symmetrierungschleife nach Anspruch 1, dadurch ge kennzeichnet, dass
$C_{min}/C_{asym} > 4$ gewählt wird, wobei $C_{min}$ die minimale einstellbare Kapazität des wenigstens einen Kondensators (C1...C8) und $C_{asym}$ die maximal auftretende Asymmetrie am Ausgang ist.

FIG.1

FIG.2

EP 0 426 988 A1

FIG.3

FIG.4

FIG.5

FIG.6

8

FIG.7

FIG.8

FIG.9

FIG.9A

FIG.9B

FIG.10A

FIG.10B

FIG.10C

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-2 187 014 (BUSCHBECK ET AL.) <br> * das ganze Dokument * <br> - - - | 1-4,7 | H 01 <br> P 5/10 <br> H 03 H 7/42 |
| D,A | H.MEINKE - F.W.GUNDLACH: "Taschenbuch der Hochfrequenztechnik;Auflage 2" 1962, SPRINGER-VERLAG, Berlin <br> * Seite 382, Zeile 10 - Seite 387, Zeile 28; Figur 18.11 * <br> - - - | 1 | |
| A | US-A-2 368 694 (WATTS) <br> * Seite 2, rechte Spalte, Zeile 48 - Seite 3, linke Spalte, Zeile 15 * * Seite 3, linke Spalte, Zeilen 26 - 49; Figuren 2, 3, 5 * <br> - - - | 7 | |
| A | US-A-3 129 393 (COLEMAN) <br> * Spalte 4, Zeilen 45 - 60; Figuren 4, 5 * <br> - - - | 8,11 | |
| A | DE-C-7 241 31 (TELEFUNKEN GESELLSCHAFT FÜR DRAHTLOSE TELEGRAPHIE GMBH) <br> * Seite 2, Zeilen 36 - 51; Figur 2 * <br> - - - - - | 11 | |
| | | | RECHERCHIERTE SACHGEBIETE (Int. Cl.5) <br><br> H 01 P <br> H 03 H |

Der vorliegende Recherchenbericht wurde für alle Patentansprüche erstellt

| Recherchenort | Abschlußdatum der Recherche | Prüfer |
|---|---|---|
| Den Haag | 04 Februar 91 | DEN OTTER A.M. |